(19) Europäisches Patentamt
European Patent Office
Office européen des brevets

(11) **EP 1 437 835 B2**

(12) **NEUE EUROPÄISCHE PATENTSCHRIFT**
Nach dem Einspruchsverfahren

(45) Veröffentlichungstag und Bekanntmachung des Hinweises auf die Entscheidung über den Einspruch:
**12.12.2012 Patentblatt 2012/50**

(45) Hinweis auf die Patenterteilung:
**28.12.2005 Patentblatt 2005/52**

(21) Anmeldenummer: **03022426.5**

(22) Anmeldetag: **07.10.2003**

(51) Int Cl.:
*H03M 7/30* (2006.01)   *G08C 17/02* (2006.01)

(54) **Verfahren zur Einsparung von Speicherplatz für eine Folge numerischer Werte**

Method for storage space reduction for a series of numerical values

Procédé d'économie de place mémoire pour une suite de valeurs numériques

(84) Benannte Vertragsstaaten:
**AT CH DE LI**

(30) Priorität: **10.01.2003 DE 10300872**
**05.03.2003 DE 10309455**

(43) Veröffentlichungstag der Anmeldung:
**14.07.2004 Patentblatt 2004/29**

(73) Patentinhaber: **Techem Energy Services GmbH**
**65760 Eschborn (DE)**

(72) Erfinder: **Hansing, Martin, Dipl.-Inf.**
**65931 Frankfurt am Main (DE)**

(74) Vertreter: **KEIL & SCHAAFHAUSEN**
**Patentanwälte**
**Cronstettenstraße 66**
**60322 Frankfurt am Main (DE)**

(56) Entgegenhaltungen:
**WO-A-00/75902     US-A- 5 323 154**
**US-A- 6 028 893     US-A1- 2002 145 537**

- **WALLACE G K: "THE JPEG STILL PICTURE COMPRESSION STANDARD" COMMUNICATIONS OF THE ASSOCIATION FOR COMPUTING MACHINERY, ASSOCIATION FOR COMPUTING MACHINERY. NEW YORK, US, Bd. 34, Nr. 4, 1. April 1991 (1991-04-01), Seiten 30-44, XP000228786 ISSN: 0001-0782**
- **PATENT ABSTRACTS OF JAPAN vol. 1995, no. 02, 31. März 1995 (1995-03-31) & JP 06 319178 A (TOSHIBA CORP), 15. November 1994 (1994-11-15)**
- **DATABASE WPI Section EI, Week 200255 Derwent Publications Ltd., London, GB; Class S01, AN 1997-524282 XP002269067 "Terminal network controller used in meter inspection of water, town gas, electric power - transmits expanded set up data when central administration unit requests its transmission" & JP 09 252354 A (SHARP K.K.)**

EP 1 437 835 B2

**Beschreibung**

Die Erfindung betrifft ein Verfahren gemäß Anspruch 1 zur Einsparung von Speicherplatz für eine Folge numerischer Werte $x_i$ in einer B-nären Zahlendarstellung mit s Stellen in einem Datenspeicher für die Speicherung und Funkübertragung von Wertehistorien in einem Verbrauchserfassungsgerät. Die Erfindung bezieht sich auch auf ein zur Durchführung des Verfahrens eingerichtetes Verbrauchserfassungsgerät gemäß Anspruch 11.

Aus der US 6,028,893 ist ein Verfahren zur Datenreduktion von Signalwerten einer digitalen Signalverarbeitungseinrichtung im Bereich mobiler Kommunikationssysteme bekannt, bei dem ein Block von Signalwerten in einem festen Dezimalpunktformat gespeichert und der Maximalwert bestimmt wird. Anschließend werden die Daten in ein Floating-Dezimalpunktformat konvertiert, wobei jeweils eigene Mantissen und ein gemeinsamer Exponent bestimmt werden. Ein ähnliches Komprimierungsverfahren ist auch aus der Bildverarbeitung bekannt (vgl. G. K. Wallace, "The JPEG Still Picture Compression Standard", Association for Computing Machinery, New York, Bd. 34, Nr. 4, Seiten 30 - 44). Ferner ist aus der JP 06319178 (Patent Abstracts of Japan) ein Übertragungsverfahren von Verbrauchswerten bekannt, bei der eine Dezimalstelle 0 bis 9 einem bestimmten Bit-Code zugeordnet wird.

DE 3411962 offenbart eine Datenübertragungseinrichtung mit einer Datenkompression, in der aus einer gegebenen Anzahl von Datenbits eine kleinere Anzahl von Datenbits für die Übertragung ausgewählt wird. Die Auswahl erfolgt anhand eines Skalierungsfaktors.

Im Bereich elektronischer (Verbrauchserfassungs-)Messgeräte für Wärme, Wasser und Heizkosten sollen bei zukünftigen Erfassungsgeräten detaillierte Historien der Verbrauchswerte gebildet und gespeichert werden. Dies können beispielsweise Tages(end)werte, Wochen(end)werte, Monatsend- und/oder Monatsmittenwerte, und/oder Jahreswerte (i. d. R. zu einem einstellbaren Stichtag, dann auch als Stichtagswert bezeichnet) sein. Die Speicherung von Wertehistorien im Gerät soll die Notwendigkeit von zeitnahen Zwischenablesungen vermeiden helfen.

US 2002 0145537 offenbart ein Verfahren und Verbrauchserfassungsgerät, in dem eine Folge von Verbrauchswerten mit Hilfe verlustfreier differentieller Kompression komprimiert und übertragen wird.

Die elektronischen Verbrauchserfassungsgeräte verfügen zur Ausübung ihrer Funktion typischerweise über einen integrierten Mikrocontroller. Die für Messzwecke einsetzbaren Mikrocontroller haben mehrheitlich relativ kleine Datenspeicher (ca. 32 bis 256 Bytes RAM bei Programmspeichergrößen von 1 kB bis 8 kB). Daher können häufig nicht sämtliche in der Wertehistorie gewünschten Werte in diesem Datenspeicher gespeichert werden. Ein größerer oder zusätzlicher Speicher verursacht dagegen höhere Kosten und soll deshalb möglichst nicht eingesetzt werden.

Daher speichern die heute üblichen Verbrauchserfassungssysteme in der Regel nur so viele Vergangenheitswerte, wie es der Mikrocontrollerspeicher zulässt. Diese werden in der Regel als absolute Zählerstände abgespeichert. Wird in der Anzeige eines elektronischen Zählers beispielsweise ein Zählerstand mit acht Dezimalstellen dargestellt, dann werden die Messwerte geräteintern typischerweise als 32-Bitwerte (8 x 4 Bit BCD = Binary Coded Decimals) verwaltet. Sollen im Messgerät ein Stichtagswert, ein Aktuellwert und Monatsendwerte für ein Jahr gespeichert werden, dann erfordert dies bei achtstelligem Zählerstand bereits: (12 Monatsendwerte + 1 Aktuellwert + 1 Stichtagswert) x 32 Bit = 448 Bit oder 56 Byte. Dies ist ein Grund, warum am Markt befindliche Erfassungsgeräte mehrheitlich auf Monatsauflösung beschränkt sind und Vergangenheitswerte für höchstens ein Jahr vorhalten können. Viele Erfassungsgeräte speichern außer dem Stichtagswert überhaupt keine zusätzlichen Vergangenheitswerte.

Am Markt befindliche Funksysteme für die wohnungswirtschaftliche Verbrauchswerterfassung verlegen die Bildung der Wertehistorien daher häufig in einen oder mehrere stationäre Empfänger. Dies hat den Vorteil, dass nur aktuelle Messwerte übertragen werden müssen und die Funkbotschaften sehr kurz sein können. Verzichtet man bei solchen Funksystemen auf stationäre Empfänger und nimmt die Ablesung nur zeitweise mit einem mobilen Empfänger vor (sog. Drive-By, Walk-By oder Walk-In-Systeme), dann ist man bei der Datenerfassung auf die Aktuellwerte der Empfangszeitpunkte beschränkt. Die Nutzung von Vergangenheitswerten für spätere Zwischenabrechnungen ist nicht möglich. Die gleichen Argumente gelten für Erfassungsgeräte, die durch Ablesen oder mit einer mobilen Datenerfassungseinheit per akustischer, induktiver oder optischer Schnittstelle abgelesen werden. Für die Ablesepraxis bedeutet das Fehlen von Vergangenheitswerten (Wertehistorie) in den Verbrauchswerterfassungsgeräten, dass neben den regulären Stichtagsablesungen auch Zwischenablesungen notwendig werden. Ein typischer und häufiger Fall, der eine Zwischenablesung des Wasser- und Wärmeverbrauchs erfordert, ist der Mieter- bzw. Eigentümerwechsel. Würden die Erfassungsgeräte historische Zählerstände speichern, könnte auf eine zeitnahe Zwischenablesung verzichtet und auf die gespeicherte Verbrauchswerthistorie im Rahmen der regulären Stichtagsablesung zugegriffen werden. Das gilt in gleicher Weise für Funkerfassungssysteme ohne stationäre Empfänger. Will man auf zeitnahe Zwischenablesungen verzichten, dann müssen die Funkbotschaften der sendenden Verbrauchserfassungsgeräte zum Zeitpunkt der Stichtagsablesung neben dem Stichtagsverbrauch auch abrechnungsrelevante Vergangenheitswerte für die abgelaufene Abrechnungsperiode enthalten. Die Granularität der wertbildenden zeitlichen Abstände, d.h. der zeitliche Abstand zwischen zwei Verbrauchswerten in der Wertehistorie, muss dabei so gewählt werden, dass sich typische Anwendungsfälle abbilden lassen. Bisherige Systeme verzichten zugunsten stationärer Empfänger auf die Funkübertragung von Verbrauchswerthistorien. Der Nachteil von Systemen mit stationär im Gebäude montierten Funkempfängern ist, dass die

Systemkosten deutlich höher ausfallen als bei Systemen ohne stationären Empfänger. Zudem gehen bei Ausfall des Empfängers alle gespeicherten Verbrauchswerthistorien sämtlicher empfangenen Sender verloren. Um dies zu vermeiden, müssen durch weitere Empfänger kostenintensive Redundanzen hergestellt werden.

Beim Einsatz der bisherigen elektronischen Verbrauchserfassungsgeräte sind Zwischenablesungen wegen des fehlenden Vergangenheitsspeichers für eine Verbrauchswerthistorie die Regel. Typischerweise macht die Ablesung einiger weniger Geräte in einer einzelnen Wohneinheit die An- und Abreise des Ablesers jedoch wirtschaftlich unrentabel.

Aufgabe der Erfindung ist es daher, eine Möglichkeit zur Einsparung von Speicherplatz für eine Folge numerischer Werte vorzuschlagen, damit in den vorhandenen Datenspeichern mit begrenzter Speicherkapazität insgesamt mehr Werte abgespeichert und Energiesperend mit geringer Kollisionswahrscheinlichkeit per Funk übertragen, werden können.

Diese Aufgabe wird erfindungsgemäß mit den Merkmalen des Anspruchs 1 gelöst. Bei einem Verfahren der eingangs genannten Art wird dazu zunächst für alle numerischen Werte $x_i$ ein gemeinsamer Normierungsfaktor $f_{NORM}$ bestimmt und in dem Datenspeicher abgespeichert. Vor der Speicherung der numerischen Werte $x_i$ in dem Datenspeicher werden diese mit dem Normierungsfaktor $f_{NORM}$ durch Division in komprimierte numerische Werte $y_i$ mit k Stellen überführt, wobei k kleiner als s ist. Bei der Überführung in die komprimierten numerischen Werte $y_i$ mit einer vorgegebenen Stellenanzahl mit k Stellen in einer B-nären Darstellung auftretende Ungenauigkeiten, wie Rundungsfehler oder Divisionsreste, führen bei der Rückführung der komprimierten numerischen Werte $y_i$ in die numerischen Werte $x_i$, die bspw. durch Multiplikation der komprimierten numerischen Werte $y_i$ mit dem Normierungsfaktor $f_{NORM}$ gewonnen werden, zu Darstellungsfehlern. Die Auswirkungen der Darstellungsfehler können aber durch geeignete Auswahl des Normierungsfaktors beliebig so eingestellt werden, dass diese entsprechend dem Anwendungsfall vertretbar sind.

Durch die mit dem erfindungsgemäßen Verfahren verbundene Datenkompression kann in einem typischen Verbrauchsmess- und -erfassungsgerät eine umfassende Verbrauchswerthistorie abgelegt werden, die im Bedarfsfall zur Verfügung steht. Ein weiterer Vorteil der Kompression der Verbrauchswerte zeigt sich bei der Datenübertragung per Funk, insbesondere bei batteriebetriebenen Geräten. Zur Übertragung einer Folge von Messwerten per Funk wird eine gewisse Energiemenge benötigt, die umso geringer ist, je kürzer die Funkbotschaften sind. Die Kompression der Dateninhalte hat im Fall der Funkaussendung daher zwei positive Effekte: zum einen wird die Batterielebensdauer der Geräte erhöht, und zum anderen reduzieren kürzere Funkaussendungen die Kollisionswahrscheinlichkeit der Funktelegramme untereinander. Dies kann bei einer großen Anzahl sendender Geräte im gleichen Empfangsbereich und bei kurzen zeitlichen Sendeabständen relevant werden.

Die Datenkompressionswirkung des erfindungsgemäßen Verfahrens ist dann besonders hoch, wenn die komprimierten numerischen Werte $y_i$ alle k Stellen in der komprimierten B-nären Darstellung nutzen. Dies kann durch eine geeignete Auswahl des Normierungsfaktors $f_{NORM}$ eingestellt werden.

Dazu wird der Normierungsfaktor $f_{NORM}$ vorzugsweise aus dem Maximalwert der numerischen Werte $x_i$ bestimmt. Wenn für eine Dezimaldarstellung bspw. vorher festgelegt wurde, dass die komprimierten numerischen Werte insgesamt k=4 Stellen haben dürfen, wird der zur Verfügung stehende Wertebereich optimal ausgenutzt, wenn der größte komprimierte numerische Wert $y_i$ = 9999 ist. Für einen größten numerischen Wert $x_i$ = 18 5476 85 ist der optimale Normierungsfaktor $f_{NORM}$ daher die größte ganze Zahl, die sich aus der Division von 18547685 / 9999 = 1854,9539 ergibt. Damit wird der Normierungsfaktor in diesem Beispiel erfindungsgemäß am besten als $f_{NORM}$ = 1855 bestimmt, der mit in dem Datenspeicher des Gerätes abgespeichert wird.

Um den Speicherplatzbedarf für den Normierungsfaktor $f_{NORM}$ so klein wie möglich zu halten, kann der Normierungsfaktor $f_{NORM}$ erfindungsgemäß als Potenz $B^E$ der B-nären Darstellung gebildet werden. In diesem Fall ist es ausreichend, lediglich den Exponenten E abzuspeichern. Allerdings ist in diesem Fall die Auswahl der Normierungsfaktoren $f_{NORM}$ deutlich beschränkt. In dem vorbeschriebenen Beispiel wäre der kleinste mögliche Normierungsfaktor in der Dezimaldarstellung, mit dem der gesamte Wertebereich der numerischen Werte $x_i$ abgebildet wird, $f_{NORM}$ = $10^4$. Mit diesem Normierungsfaktor $f_{NORM}$ wird jedoch der zur Verfügung stehende, 4-stellige Wertebereich für die komprimierte Darstellung wesentlich schlechter ausgenutzt, wodurch sich der Darstellungsfehler vergrößert. Bei der Auswahl dieser Verfahrensvariante ist der Vorteil der Speichererspamis gegenüber dem Nachteil des vergrößerten Darstellungsfehlers für den Anwendungsfall abzuwägen. Bspw. kann die Auswahl eines exponentiellen Normierungsfaktors $f_{NORM}$ immer dann erfolgen, wenn mit einem solchen Normierungsfaktor durch die erzeugten Werte $y_i$ mehr als ein vorgegebener Prozentsatz des zur Verfügung stehenden Wertebereichs für die komprimierte Darstellung abgedeckt wird.

Eine wesentliche Verbesserung in der Genauigkeit der komprimierten Daten kann erfindungsgemäß dadurch erreicht werden, dass bei der Überführung der numerischen Werte $x_i$ in die komprimierten numerischen Werte $y_i$ auftretende Ungenauigkeiten, wie Rundungsfehler oder nicht berücksichtigte Divisionsreste, in einem Fehlerakkumulator F aufakkumuliert werden. Bei numerischen Werten, die insbesondere einen fortschreitenden Verbrauch inkrementell erfassen, kann der Fehlerakkumulator F zu einem ausgewählten numerischen Wert $x_i$ hinzuaddiert werden, bevor dieser in einen komprimierten Wert überführt wird. Dafür bietet sich bspw. der in größeren Zeitintervallen wie einem Jahr abgelesene Stichtagswert an. Dadurch summieren sich die Ungenauigkeiten nicht auf, so dass der im Normfall entscheidende Stichtagswert besonders genau ist.

In einer vorteilhaften Weiterentwicklung dieser Idee kann der komprimierte numerische Wert $y_i$ erfindungsgemäß aufgerundet und der Fehlerakkumulator F entsprechend vermindert werden, sobald der Fehlerakkumulator F eine vorgebbare Schwelle überschreitet. Dadurch findet eine zeitnahe Korrektur der Darstellungsfehler statt. Bspw. kann in einer einfach zu realisierenden Umsetzung des Verfahrens die vorgebbare Schwelle gerade die Hälfte des Normierungsfaktors $f_{NORM}$ betragen und der Fehlerakkumulator F um den Normierungsfaktor $f_{NORM}$ vermindert werden, sobald die Schwelle überschritten ist. In diesem Fall werden die zu dem Fehlerakkumulator F kumulierten Ungenauigkeiten durch die mathematische Beziehung $F_i = x_i \bmod f_{NORM}$ bestimmt. Natürlich können die Schwelle und die Bestimmung der Einzelfehler $F_i$ auch auf andere Weise erfolgen.

Gemäß einer erfindungsgemäßen Variante des vorgeschlagenen Verfahrens besteht die Möglichkeit, zu jedem komprimierten numerischen Wert $y_i$ einen zugehörigen Rundungsfehler $r_i$ mit abzuspeichern. Der Rundungsfehler $r_i$ kann bspw. dem vorgenannten Einzelfehler $F_i$ entsprechen. Diese Verfahrensvariante eignet sich besonders für den Fall, dass der Liste mit numerischen Werten $x_i$ sukzessive neue Werte hinzugefügt und/oder alte Werte entfernt werden, so dass jeweils eine Aktualisierung des Normierungsfaktors $f_{NORM}$ und damit eine wiederholte Bereichsanpassung der komprimierten Werte notwendig wird. Mit den zusätzlich abgespeicherten Rundungsfehlern $r_i$ lassen sich die Werte $x_i$ ohne Aufakkumulierung der Darstellungsfehler wiederholt komprimieren und dekomprimieren. Damit ist eine verlustfreie Rückgewinnung der numerischen Werte $x_i$ aus den komprimierten numerischen Werten $y_i$ und den Rundungsfehlern $r_i$ möglich, so dass der Normierungsfaktor $f_{NORM}$ ohne Qualitätseinbußen neu bestimmt und optimal gewählt werden kann, wenn sich die Folge numerischer Werte $x_i$ ändert.

Insbesondere bei Verbrauchserfassungsgeräten kann es vorteilhaft sein, wenn mindestens ein ausgewählter numerischer Wert $x_i$ unkomprimiert abgespeichert wird. Dies ist dann vorzugsweise der Stichtagswert, der im Normalfall für eine Verbrauchskostenabrechnung herangezogen wird.

Diese Ausgestaltung des erfindungsgemäßen Verfahrens eignet sich besonders für den Fall, dass vor der Anwendung des Normierungsfaktors $f_{NORM}$ aus jeweils aufeinanderfolgenden numerischen Werten $x_i$ und $x_{i-1}$ jeweils ein Differenzwert $d_i$ gebildet wird und die Differenzwerte $d_i$ mit dem Normierungsfaktor $f_{NORM}$ in die komprimierten numerischen Werte $y_i$ mit k Stellen überführt werden. Die Differenzwerte sind bspw. bei einem fortschreitenden Verbrauch von Wärme, Strom, Gas und dgl. kleiner als absolute Zählerstände, so dass sich durch diese Variante der benötigte Speicherplatz weiter reduziert. Besonders vorteilhaft ist es, wenn der erste numerische Wert $x_0$, der deutlich größer ist als die Differenzwerte $d_i$, unkomprimiert abgespeichert wird, da dieser dann bei der Bestimmung des Normierungsfaktors $f_{NORM}$ und der Anzahl k der Stellen der komprimierten Darstellung außer acht bleiben kann.

In Weiterführung des Erfindungsgedankens kann das vorgeschlagene Verfahren die Anzahl k der Stellen der komprimierten numerischen Werte $y_i$ abhängig von der gewünschten Genauigkeit selbsttätig festlegen. Dazu lässt sich bei einem gewünschten maximal tolerierbaren Darstellungsfehler $F_{REL}$ die Anzahl k der benötigten Stellen für die Zahlendarstellung zur Basis B durch die Beziehung

$$k = \left\lceil \log_B \left( \frac{1}{F_{REL}} \right) \right\rceil = \left\lceil -\log_B (F_{REL}) \right\rceil$$

ermitteln, wobei $\lceil x \rceil$ die kleinste ganze Zahl $\geq x$ ist. Ist beispielsweise ein Darstellungsfehler von $F_{REL} = 0{,}1$ % zulässig, dann werden für die Binärdarstellung der komprimierten numerischen Werte $y_i$ mindestens $k = \lceil -\log_2(0{,}001) \rceil = 10 \, Bit$ benötigt.

Die vorliegende Erfindung betrifft ferner ein Verbrauchserfassungsgerät mit einen Verbrauchserfassungssensor, einem Datenspeicher zum Abspeichern der erfassten Verbrauchswerte und einer Recheneinheit, die u.a. zur Durchführung des vorbeschriebenen Verfahrens eingerichtet ist und die Verbrauchswerte als komprimierte numerische Werte $y_i$ in dem Datenspeicher ablegt. In dem Verbrauchserfassungsgerät ist auch ein Funksender zur Übertragung der als komprimierte numerische Werte $y_i$ vorliegenden Verbrauchswerte vorgesehen.

In einer typischen Anwendung des erfindungsgemäßen Verfahrens werden die numerischen Werte binär dargestellt. Die Zahlenbasis ist also B = 2, so dass die Zahlendarstellung mit Binärstellen (Bits) erfolgt. Ein mit einem Exponent E gebildeter Normierungsfaktor $f_{NORM}$ nimmt ebenfalls nur die Werte der Zweierpotenzen $2^E$ an.

Weiterbildungen, Vorteile und Anwendungsmöglichkeiten der Erfindung ergeben sich auch aus der nachfolgenden Beschreibung von Ausführungsbeispielen und der Zeichnungen. Dabei sind alle beschriebenen und/oder bildlich dargestellten Merkmale für sich oder in beliebiger Kombination Teil der Erfindung, unabhängig von ihrer Zusammenfassung in den Ansprüchen oder deren Rückbeziehung.

Es zeigen:

Fig. 1    den Wertebereich und Speicherbedarf für kumulierte Verbrauchswerte in tabellarischer Übersicht;

Fig. 2 die Transformation in komprimierte numerische Werte $y_i$ mit der dazugehörigen Rücktransformation in tabellarischer Übersicht;

Fig. 3 eine Übersicht über den Speicherbedarf von Normierungsfaktoren $f_{NORM}$ als Binärexponent und freier Normierungsfaktor;

Fig. 4 ein Ablaufdiagramm für ein erfindungsgemäßes Rundungsverfahren mit einem frei gewählten Normierungsfaktor f

Fig. 5 ein Ablaufdiagramm für ein erfindungsgemäßes Rundungsverfahren mit einem als binärer Exponent $2^E$ gewählten Normierungsfaktor E;

Fig. 6 ein Ablaufdiagramm für ein erfindungsgemäßes Rundungsverfahren bei Speicherung der Rundungsfehler $r_i$ mit einem Normierungsfaktor f;

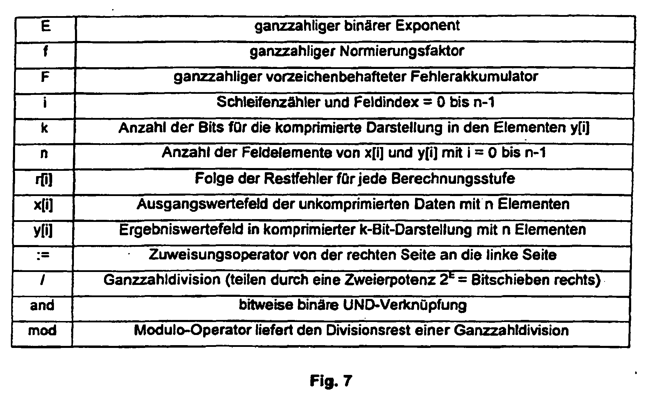

Fig. 7 eine Legende der Variablen und Operatoren für die Ablaufdiagramme gemäß Fig. 4 bis 6.

Das erfindungsgemäße Verfahren wird nachfolgend anhand von Verbrauchszählern beschrieben.

Es gibt grundsätzlich zwei Arten von elektronischen Verbrauchszählern:

1) Rückstellende Zähler, die zu einem Stichtag am Ende der Abrechnungsperiode den akkumulierten Verbrauch speichern und anschließend den aktuellen Zählerstand für die neue Abrechnungsperiode zurücksetzen. Elektronische Heizkostenverteiler sind ein typisches Beispiel für rückstellende Zähler.

2) Nichtrückstellende Zähler: sie akkumulieren den gemessenen Verbrauch über die gesamte Einsatzzeit auf, erreichen dabei größere Zählerstände und benötigen daher mehr Zählerstellen zur Darstellung und Speicherung der Messwerte. Wasser-, Wärme-, Strom- und Gaszähler sind typische Beispiele für nichtrückstellende Zählwerke.

Mit dem angegebenen Verfahren wird für beide Arten von Zählern eine Datenkompression realisiert, die sowohl für eine platzsparende interne Speicherung der Werte als auch für eine Verkürzung von Funkbotschaften mit Verbrauchswerthistorien geeignet ist. Auftretende Rundungsfehler oder dgl. Ungenauigkeiten des Verfahrens können sich dabei über die komprimierte Wertefolge nicht zu einem unzulässigen Gesamtfehler akkumulieren.

Da es sich bei wohnungswirtschaftlichen Verbrauchswerten um über die Zeit akkumulierte numerische Werte $x_i$ handelt, besteht ein erster optionaler Reduktionsschritt darin, anstelle absoluter Verbrauchszählerstände (Werte $x_i$) jeweils die Differenz $d_i = x_i - x_{i-1}$ zum vorhergehenden Zählerstand zu bilden, wobei sich die erste Differenz auf einen Startwert $d_0 = x_0$ mit voller numerischer Auflösung bezieht. Je geringer die zeitlichen Abstände zwischen den Werten einer Verbrauchswerthistorie sind, desto kleiner kann der Wertebereich für die Differenzen zwischen diesen Werten gewählt werden, da in kürzeren Zeitintervallen weniger Verbrauch akkumuliert wird. Abrechnungsszenarien, zulässige Zeittoleranzen und die typischen Zeitpunkte von Zwischenablesungen bestimmen die zeitliche Granularität von der im Gerät gespeicherten Verbrauchswerthistorie, d.h. die zeitlichen Abstände zwischen gespeicherten Verbrauchswerten. Typische Zeitabstände sind Monats(end)werte, Halbmonatswerte (zur Monatsmitte und zum Monatsende), Wochenwerte oder Tages(end)werte.

Bei vergleichbarer Darstellungsgenauigkeit und geringer Schwankungsbandbreite des Verbrauchs ist für Monatsdifferenzen ein etwa dreißig mal größerer Wertebereich vorzusehen als für Tagesdifferenzen. Für Monatsdifferenzen sind gegenüber Tagesdifferenzen $\lceil \log_B (31) \rceil$ zusätzliche Stellen in einer Zahlendarstellung zur Basis B empfehlenswert. Für die Binärdarstellung sind dies $\lceil \log_2 (31) \rceil = 5\,Bit$ zusätzlich pro Monatswert. Bei Halbierung des Speicherintervalls kann ohne Genauigkeitsverlust eine Binärstelle (1 Bit) eingespart werden. Bei Verdopplung des Zeitintervalls ist eine Binärstelle mehr zu veranschlagen. Bei einer Abrechnungsperiode von einem Jahr benötigen 366 Tageswerte dennoch wesentlich mehr Speicherplatz als 52 Wochenwerte mit einem 7-mal grö-ßeren Wertebereich (3 Bit zusätzlich pro Wert) oder als 12 Monatswerte mit einem 31-mal größeren Wertebereich (5 Bit zusätzlich pro Wert). Die zeitliche Auflösung der Verbrauchswerthistorie ergibt sich aus dem jeweiligen Anwendungsfall, dem verfügbaren Speicherplatz und der geforderten Darstellungsgenauigkeit.

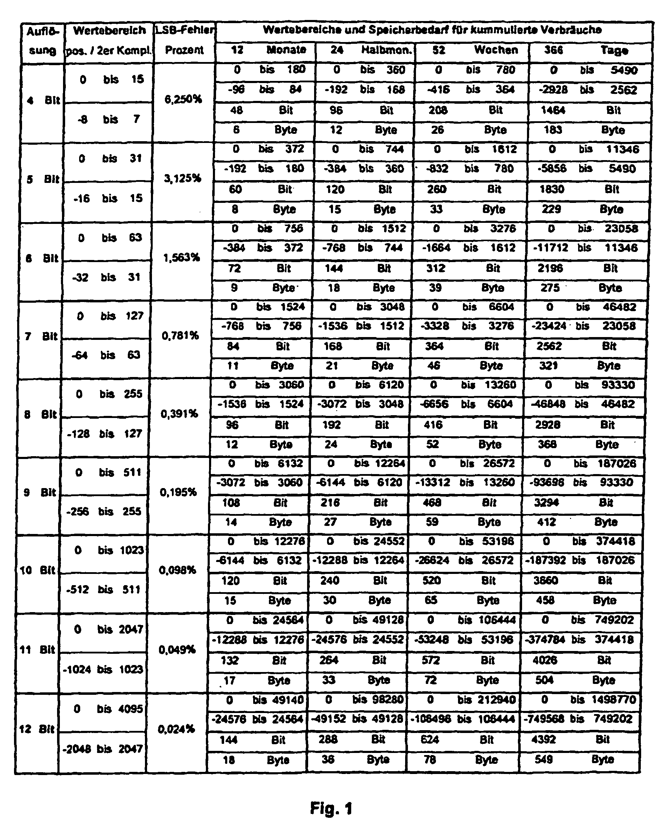

Wird ein Grenzwert $F_{REL}$ für einen maximal tolerierbaren Darstellungsfehler vorgegeben, dann lässt sich die minimale Anzahl benötigter Stellen k für die Zahlendarstellung zur Basis B direkt durch die Beziehung $k = \lceil -\log_B(F_{REL}) \rceil$ bestimmen, wobei $\lceil x \rceil$ die kleinste ganze Zahl $\geq x$ ist. Die Tabelle gemäß Fig. 1 gibt eine exemplarische Übersicht über Zahlenbereiche, Darstellungsfehler, Grenzwerte für kumulierte Zahlenbereiche und Speicherbedarf jeweils für die binäre Darstellung positiver ganzer Zahlen und die binäre Zweierkomplementdarstellung.

Um den tolerierbaren Darstellungsfehler nicht unzulässig zu vergrößern, ist es notwendig, die zu komprimie-

renden numerischen Werte $y_i$ auf den Zahlenbereich mit k Stellen {0 bis $B^k-1$} anzupassen. Dies könnte für jeden numerischen Wert $x_i$ mit individuellen Normierungsfaktoren erfolgen, die jedoch alle abgespeichert werden müssten. Daher führt die Einführung einer großen Anzahl individueller Normierungsfaktoren nicht zu dem gewünschten Ziel der Speicherplatzersparnis. Das vorgeschlagene Verfahren beruht dagegen auf der Idee, einen einzigen Normierungsfaktor für alle Werte einer Wertehistorie zu verwenden, wobei aus dem größten Wert der Wertehistorie $x_{MAX} = \max(x_0,x_1,x_2,....,x_{n-1})$ oder $d_{MAX} = \max(d_0,d_1,d_2,...,d_{n-1})$ der Normierungsfaktor $f_{NORM}$ bestimmt wird. Die $d_i$ stellen dabei die auf Differenzwerte verkürzte Form der Wertehistorie dar. Wenn der erste Wert $d_0$ als Startwert unkomprimiert gespeichert wird, kann der der Maximalwert auch aus $d_{MAX} = \max(d_1,d_2,...,d_{n-1})$ bestimmt werden. Der Normierungsfaktor $f_{NORM}$ zur Ausnutzung des Zahlenbereichs 0 bis $B^k-1$ berechnet sich wie folgt:

$$f_{NORM} = \left\lceil \frac{d_{MAX}}{B^k - 1} \right\rceil ,$$

wobei $\lceil x \rceil$ die kleinste ganze Zahl $\geq$ x ist.

Für die informationstechnisch gebräuchliche Binärdarstellung ist B = 2 einzusetzen.

Um von einer umkomprimierten Darstellung der n Werte beinhaltenden numerischen Wertehistorie $x_i$, $i \in \{0,1,...,n-1\}$ mit s Stellen zu einer komprimierten Darstellung von n Werten $y_i$, $i \in \{0, 1,..., n-1\}$ mit k Stellen zu kommen, werden zunächst die Differenzen $d_i$, $i \in \{0,1,...,n-1\}$ zwischen zeitlich aufeinanderfolgenden Werten $W(t_i)$, $i \in \{0,1,...,n-1\}$ gebildet, wobei $W(t_i)$ vorzugsweise gleich $x_i$ ist.

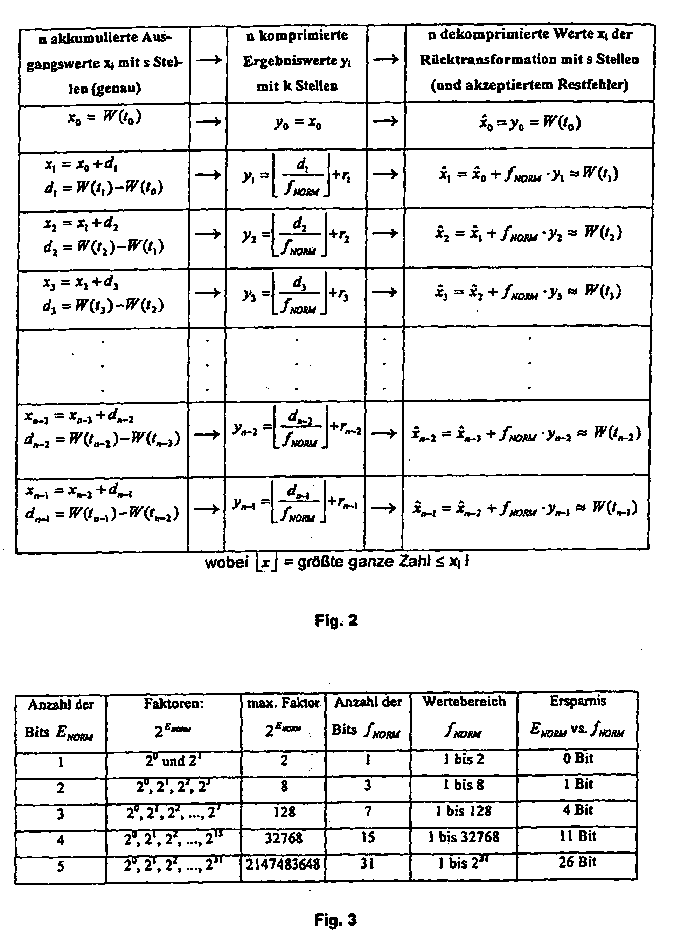

Zur Überführung der unkomprimierten, numerischen (Differenz-)Werte $d_i$ mit s Stellen in komprimierte numerische Werte $y_i$ werden die Werte $d_i$ ganzzahlig durch den berechneten Normierungsfaktor $f_{NORM}$ dividiert und ggf. abhängig von in einem Fehlerakkumulator F akkumulierten Divisionsresten $F_i = x_i \bmod f_{NORM}$ aufgerundet. Sie ergeben damit die komprimierte Darstellung $y_i$ der Ausgangswerte $x_i$ bzw. $W(t_i)$. Die individuellen Rundungs- bzw. Restfehler $r_i$ der komprimierten Werte $y_i$ werden als additive Terme $r_i \in \{0,1\}$ aufgeführt, die sich aus den abgeschnittenen Nachkommastellen der ganzzahligen Division ergeben. Eine Rücktransformation in Absolutwerte $x_I \approx W(t_i)$ erfolgt durch Multiplikation der komprimierten Werte $y_i$ mit dem Normierungsfaktor $f_{NORM}$ und anschließender sukzessiver Addition der Reihenelemente. Fig. 2 gibt eine Übersicht über diese Transformationen.

Eine Variante des Verfahrens sieht zur weiteren Speicherplatzersparnis vor, den Normierungsfaktor lediglich als Exponenten $E_{NORM}$ zur Basis B des benutzten Zahlensystems darzustellen. Diese Variante hat den Vorteil, dass zum einen eine verkürzte Darstellung des Wertes von $f_{NORM} = B^{E_{NORM}}$ allein durch den Exponenten $E_{NORM}$ möglich ist und sich zum anderen die Komprimierung der Zahlendarstellung auf das Abschneiden von Stellen reduziert. Dadurch lässt sich das Verfahren mit einem kleineren Programm in den Speicher des Verbrauchserfassungsgerätes implementieren, was zu einer weiteren Reduzierung des benötigten Speicherplatzes führt. Ein Vergleich zwischen verschiedenen Normierungsfaktoren $f_{NORM}$ in Binärdarstellung (B = 2) lässt sich Fig. 3 entnehmen, wobei die unterschiedliche Programmgröße nicht berücksichtigt wurde.

Der freie Normierungsfaktor $f_{NORM}$, der nicht durch einen binären Exponenten gebildet wird, kann mit der in der tabellarischen Übersicht gemäß Fig. 3 angegebenen Anzahl von Bits dargestellt werden, wenn statt $f_{NORM} \rightarrow f_{NORM}$ -1 abgespeichert wird. Dies ist zulässig, da $\min(f_{NORM}) = 1$ ist.

Ein Nachteil der Exponentendarstellung macht jedoch sich bemerkbar, wenn der Normierungsfaktor Werte annimmt, die gerade etwas größer als eine Potenz zur Basis B sind. Die komprimierten Ergebniswerte $y_i$ nutzen in diesem Fall den zur Verfügung stehenden Zahlenbereich von 0 bis $B^k$- 1 nicht vollständig aus und verschenken damit Genauigkeit bzw. Speicherplatz. Dies wird nachfolgend durch eine Gegenüberstellung eines freien Normierungsfaktors und eines als binärer Exponent gebildeten Normierungsfaktors anhand eines konkreten Beispiels erläutert.

Der Wert $x_i$ = 17000 soll mit 8 Bit binär dargestellt werden. Es ergibt sich ein freier Normierungsfaktor von $f_{NORM} = \lfloor 17000/(2^8 -1) \rfloor = 67$. Die komprimierte 8-Bit-Darstellung errechnet sich also zu $y_i = \lceil 17000/f_{NORM} \rceil = 254$. Der Darstellungsfehler beträgt $1 - \frac{254 \cdot 67}{17000} \approx 0,1\%$.

Mit einem Binärexponenten von $E_{NORM}$ =6, der einem Normierungsfaktor von $f_{NORM} = 2^6 = 64$ entspricht, lässt sich der Wert $x_i$ = 17000 in 8 Bit nicht unterbringen, da 17000 / 64 > 255 = $2^8-1$ ist. Der nächst größere binäre Exponent $E_{NORM}$ = 7 führt zu einem Normierungsfaktor $f_{NORM} = 2^7 = 128$. Die gerundete 8-Bit-Binärdarstellung von 17000 ist folglich $y_i = \lfloor 17000/2^E \rfloor = 133$. Der Darstellungsfehler ergibt sich damit zu $1 - \frac{133 \cdot 128}{17000} \approx 0,14\%$.

Es ist offensichtlich, dass der mögliche Zahlenbereich der 8-Bit-Binärdarstellung (0 bis 255) in diesem Beispiel schlecht genutzt wird. Für Werte die kleiner oder gleich 133 sind werden informationstheoretisch nur $\log_2(133) \approx 7,06 Bit$

benötigt. Der resultierende Rundungsfehler der binären Exponentendarstellung für den Normierungsfaktor ist bei ungünstigen Normierungsfaktoren als etwa doppelt so groß anzunehmen, verglichen mit der Darstellung über einen freien Normierungsfaktor.

Der Vorteil der Bereichsanpassung von Verbrauchswertdifferenzen mit Normierungsexponenten ist, dass das Kompressionsverfahren ohne "echte" Ganzzahldivision auskommt, da die Division durch Potenzen $B^E$ dem Abschneiden von Stellen in der B-nären Zahlendarstellung entspricht. Insbesondere in der Binärdarstellung kann die Division durch Zweierpotenzen durch Bitschiebeoperationen realisiert werden. Dies kann abhängig von den zur Verfügung stehenden Arithmetikoperationen des Mikrocontrollers vorteilhaft sein.

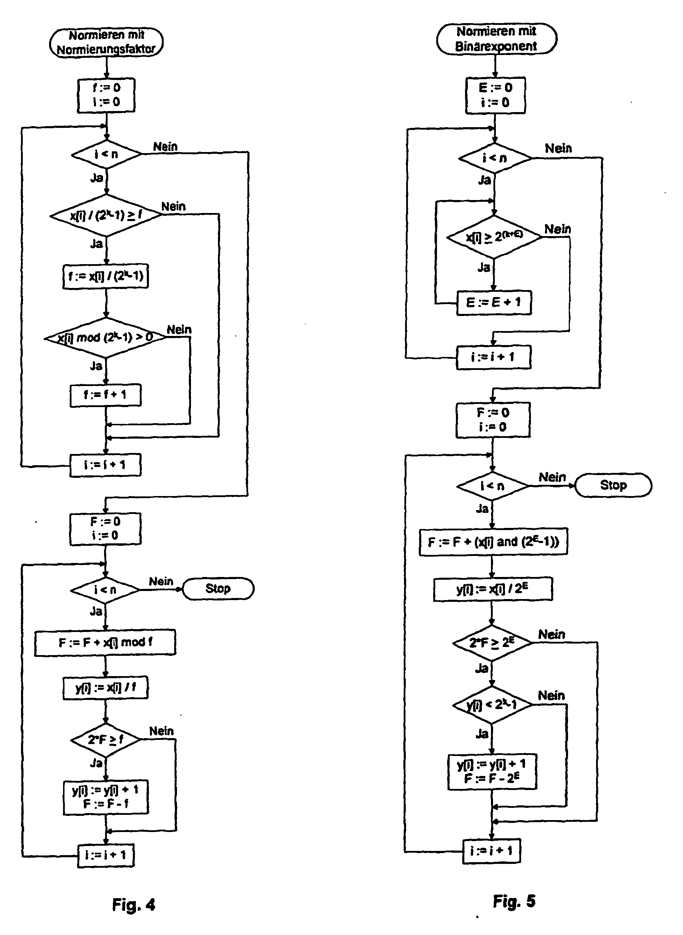

Beim Komprimieren der Ausgangswerte entstehen Divisionsreste oder niederwertige Stellen, die abgeschnitten werden. Um zu vermeiden, dass sich Rundungsfehler akkumulieren, wird jeweils ein Rundungsverfahren für die Variante des freien Normierungsfaktor (siehe Fig. 4) und den als Binärexponent gebildeten Normierungsfaktor (siehe Fig. 5) vorgeschlagen, das beim Transformieren der Zahlendarstellung Divisionsreste bzw. abgeschnittene Binärstellen für jeden Ergebniswert $y_i$ in einem Fehlerakkumulator F aufsummiert. Überschreitet der Fehlerakkumulator F eine zulässige Grenze für Rundungsfehler (hier: die Hälfte des Werts der niederwertigsten Stelle von der komprimierten Darstellung), dann wird der Ergebniswert y, aufgerundet und der Fehlerakkumulator um den Normierungsfaktor ($f_{NORM}$ bzw. $B^{E_{NORM}}$) nach unten korrigiert. Dies stellt sicher, dass beim Komprimieren Divisionsreste bzw. abgeschnittene Stellen nicht unberücksichtigt bleiben und sich zu einem unzulässig großen Gesamtfehler aufsummieren können. Das angegebene Verfahren für Binärexponenten lässt sich sinngemäß auf andere B-näre Zahlendarstellungen übertragen.

Eine Variante des Verfahrens sieht die Überführung (Kompression) einer Folge von n numerischen Eingangswerten $x_i$ in eine Folge von n komprimierten numerischen Ausgangswerten $y_i$ vor, wobei die bei jedem Verfahrensschritt auftretenden akkumulierten Divisionsreste $r_i$ mit abgespeichert werden. Diese Variante eignet sich insbesondere für die platzsparende Übertragung einer Liste numerischer Werte $x_i$, wobei der Liste sukzessive neue Werte $x_i$ hinzugefügt werden und/oder alte Werte $x_i$ entfernt werden, so dass jeweils eine Aktualisierung des Normierungsfaktors $f_{NORM}$ und damit eine wiederholte Bereichsanpassung der komprimierten Werte $y_i$ notwendig wird. Dazu ist es wünschenswert, in der Datenquelle nicht alle unkomprimierten Werte $x_i$ in voller Auflösung zusätzlich zu den komprimierten Werten $y_i$ speichern zu müssen. Die vorgeschlagene Verfahrensvariante erlaubt es, aus den komprimierten Werten $y_i$ und den zugehörigen gespeicherten Restfehlern $r_i$ die Eingangswerte $x_i$ verlustfrei zurück zu gewinnen, um das wiederholte Komprimieren und Dekomprimieren der Werte speicherplatzsparend durchführen zu können. Der Empfänger der Nachricht kann die komprimierten Daten $y_i$ nur verlustbehaftet mit dem vorgegebenen, darstellungsabhängigen Fehler dekomprimieren, da die in der Datenquelle bzw. dem Datenspeicher gespeicherten Restfehler $r_i$ nicht mit übertragen werden. Dies ist kein Nachteil, da beim Empfänger die Daten nur einmalig dekomprimiert werden, so dass sich die Darstellungsfehler nicht schädlich akkumulieren können. In der Datenquelle würde demgegenüber eine mehrfach ausgeführte verlustbehaftete Dekompression der Daten zu unzulässig großen Gesamtfehlern führen.

Bei dieser Verfahrensvariante wird x, als positive ganze Zahl mit k + m Bit abgespeichert, wobei $x_i \in [0,..., 2^{k+m} - 2^m]$ ist. Dabei werden k und m so ausgewählt, dass der Maximalwert $\max(x_n) < 2^{k+m} - 1$ ist, d. h. der binäre Zahlenbereich nicht voll ausgeschöpft wird. Der Normierungsfaktor $f_{NORM}$, der nachfolgend auch verkürzt mit $f$ bezeichnet wird, wird als positive ganze Zahl $f - 1$ mit m Bit abgespeichert, d.h. $f \in \llcorner 1,..., 2^m \lrcorner \Leftrightarrow f - 1 \in \llcorner 0,..., 2^m - 1 \lrcorner$. Für den komprimierten numerischen Wert $y_i$ stehen k Bit in einer Darstellung als ganze positive Zahl zur Verfügung ($y_i \in \llcorner 0,..., 2^k - 1 \lrcorner$). Der Rundungsfehler $r_i$ wird in einer 2er-Komplementdarstellung mit m Bit gespeichert, so dass dieser den Wertebereich $r_i \in \llcorner -(2^{m-1}),..., 0,..., 2^{m-1} - 1 \lrcorner$ umfasst. Das vorstehend verwendete Symbol $\llcorner x \lrcorner$ bedeutet dabei die größte ganze Zahl $\leq x$.

Zur Überführung (Kompression K(x)) einer Liste von n numerischen Werten $x_i$ in eine Liste von n komprimierten numerischen Werten $y_i$ wird dann die Rechenvorschrift

$$y_i = \left\lfloor \frac{x_i}{f} \right\rfloor + e_i, \ \textit{für} \ 1 \leq i \leq n$$

angewendet, wobei

$$e_i = \begin{cases} 1 & \textit{falls } 2 \cdot (x_i \bmod f + r_{i-1}) \geq f \\ 0 & \textit{sonst} \end{cases},$$

für $1 \leq i \leq n$ ist. Für die akkumulierten Reste $r_i$ gilt $r_0 = 0$ und $r_i = r_{i-1} + (x_i \bmod f) - e_i \cdot f$, für $1 \leq i \leq n$.

Die Rückführung (Dekompression D(y)) der n komprimierten Werte $y_i$ zurück in die n Ausgangswerte $x_i$ kann ohne Darstellungsverluste durch $x_i = y_i \cdot f + r_i - r_{i-1}$, für $1 \leq i \leq n$ erfolgen, wobei $r_0 = 0$.

Die Identität $D(K(x_i)) = x_i$ kann durch die folgende Rechnung nachvollzogen werden:

$$x_i = y_i \cdot f + r_i - r_{i-1}$$

$$x_i = \left(\left\lfloor \frac{x_i}{f} \right\rfloor + e_i \right) \cdot f + \left(r_{i-1} + x_i \bmod f - e_i \cdot f\right) - r_{i-1}$$

$$x_i = \left\lfloor \frac{x_i}{f} \right\rfloor \cdot f + x_i \bmod f + \left(e_i \cdot f - e_i \cdot f\right) + \left(r_{i-1} - r_{i-1}\right)$$

$$x_i = \left\lfloor \frac{x_i}{f} \right\rfloor \cdot f + x_i \bmod f .$$

Für diese Verfahrensvariante werden die n Ausgangswerte $x_i$ in einer MSB/LSB-Aufteilung $y_i$ und $r_i$ gespeichert, wobei gilt:

MSB-Anteil:  
$$y_i = \left\lfloor \frac{x_i}{2^m} \right\rfloor;$$
$y_i \in [0,...,2^k - 1]$

LSB-Anteil:  
$r_i = x_i \bmod \overline{2^m}; r_i \in r_i \in [0,...,2^m - 1]$

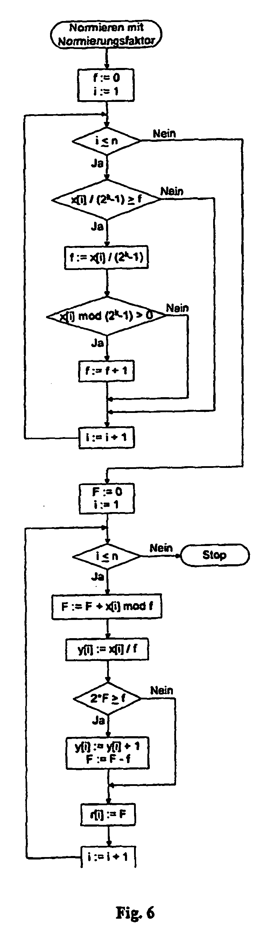

Der Ablauf des Kompressionsverfahrens für diese Verfahrensvariante ist in Fig. 6 dargestellt.

Die verlustfreie Dekompression innerhalb der Datenquelle kann mit der wiederholten Anwendung der bereits beschriebenen einfachen Rechenvorschrift $x_i = y_i \cdot f + r_i - r_{i-1}$, für $1 \leq i \leq n$ und $r_0 = 0$ geschehen, so dass hierfür ein Ablaufdiagramm nicht explizit angegeben wird.

Nachfolgend werden noch Beispiele für die Anwendung des erfindungsgemäßen Verfahrens gegeben.

**Beispiel 1**

Die Werte $x_i$ werden als Folge positiver ganzer Zahlen $x_i \in \lfloor 0,..., 65280 = 2^{16}-2^8 \rfloor$ mit 8 + 8 = 16 Bit abgespeichert, wobei $\max(x_i) < 65535 = 2^{16}-1$ ist, d. h. der binäre Zahlenbereich nicht ausgeschöpft wird. Der Normierungsfaktor $f$ - 1 als positive ganze Zahl mit 8 Bit umfasst somit den Wertebereich $f \in \lfloor 1,..., 256 = 2^8 \rfloor \Leftrightarrow f\text{-}1 \in \lfloor 0,..., 255 = 2^8\text{-}1 \rfloor$. Die komprimierte Werten $y_i$ werden als positive ganze Zahlen $y_i \in \lfloor 0,..., 255 = 2^8\text{-}1 \rfloor$ mit 8 Bit und die akkumulierten Reste $r_i$ in 2er-Komplementdarstellung ebenfalls mit 8 Bit gespeichert, so dass $r_i \in \lfloor -(2^7) = -128,...,0,..., 127 = 2^7\text{-}1 \rfloor$.

Für diese Verfahrensvariante werden die n Ausgangswerte $x_i$ in einer MSB/LSB-Aufteilung $y_i$ und $r_i$ gespeichert, wobei gilt:

8 Bit MSB-Anteil:  
$$y_i = \left\lfloor \frac{x_i}{2^8} \right\rfloor;$$
$y_i \in [0,..., 255 = 2^8 - 1]$

8 Bit LSB-Anteil:  
$r_i = x_i \bmod 2^8; r_i \in [0,..., 255 = 2^8 - 1]$

**Beispiel 2**

Die Werte $x_i$ werden als Folge positiver ganzer Zahlen $x_i \in [0,...,65472 = 2^{16}-2^6]$ mit 10 + 6 = 16 Bit abgespeichert, wobei $\max(x_i) < 65535 = 2^{16}-1$ ist, d. h. der binäre Zahlenbereich nicht ausgeschöpft wird. Der Normierungsfaktor $f$ - 1 als positive ganze Zahl mit 6 Bit umfasst somit den Wertebereich $f \in \lfloor 1,..., 64 = 2^6 \rfloor \Leftrightarrow f\text{-}1 \in \lfloor 0,..., 63 = 2^6\text{-}1 \rfloor$. Die komprimierten Werte $y_i$ werden als positive ganze Zahlen $y_i \in \lfloor 0,..., 1023 = 2^{10}\text{-}1 \rfloor$ mit 10 Bit und die akkumulierten Reste $r_i$ in

2er-Komplementdarstellung mit 6 Bit gespeichert, so dass $r_i \in \lfloor -(2^5) = -32, ..., 0, ..., 31 = 2^5 - 1 \rfloor$.

Für diese Verfahrensvariante werden die n Ausgangswerte $x_i$ in einer MSB/LSB-Aufteilung $y_i$ und $r_i$ gespeichert, wobei gilt:

10 Bit MSB-Anteil:      6 Bit LSB-Anteil:

$$y_i = \left\lfloor \frac{x_i}{2^{10}} \right\rfloor; \quad\quad y_l \in [0, ..., 1023 = 2^{10} - 1] \quad r_i = x_i \bmod 2^6 ; r_l \in [0, ..., 2^6 - 1]$$

oder

8 Bit MSB-Anteil:      8 Bit LSB-Anteil:

$$y_i = \left\lfloor \frac{x_i}{2^8} \right\rfloor; \quad\quad y, \in [0, ..., 255 = 2^8_i - 1] \quad r_l = x_l \bmod 2^8 ; r_l \in [0, ..., 255 = 2^8 - 1]$$

**Beispiel 3: Wasserzähler**

Eine konkrete Anwendung des Verfahrens ergibt sich bspw. bei einem Wasserzähler, der typischerweise fünf Stellen zur Anzeige von Kubikmetern und acht Nachkommastellen zur Anzeige von Litern, insgesamt also acht relevante Stellen, hat. Diese werden zur Darstellung auf einem Display in Form von acht BCD-Ziffern ä 4 Bit im Zählerrechenwerk bzw. Datenspeicher abgelegt. Möchte man in dem Wasserzähler 52 Wochenwerte abspeichern, erfordert dies unkomprimiert 52 x 4 Byte = 208 Byte freien Speicherplatz. Dies ist mit dem RAM-Speicher kostengünstiger Mikrocontroller (bis 256 Byte RAM) gar nicht oder schwer machbar, da auch für das Programm zur Steuerung der Funktionen des Wasserzählers Speicherplatz benötigt wird.

Mit den 8 Dezimalstellen kann der Zahlenbereich 0000,000 m$^3$ bis 99999,999 m$^3$ abgebildet werden. Legt man die ganzzahlige Literdarstellung zugrunde, dann kann der Zahlenbereich binär mit 27 Bit (0 bis 134217727 Liter) dargestellt werden. Lässt man einen Darstellungsfehler von 0,1% zu, dann wird für jede Monatsdifferenz 10 Bit (Wertebereich: 0 bis 1023) benötigt. Der maximale Wochenverbrauch in Litern ergibt sich durch $Q_{MAX}[l/h] \cdot 24[h/d] - 7[d]$, wobei $Q_{MAX}$ den maximalen Stundenverbrauch in Litern angibt. In einem typischen Fall eines $Q_{MAX}$ von 3000[l/h] sind dies höchstens 504000 Liter pro Woche. Der Maximalwert für den Normierungsfaktor ergibt sich damit zu: $f_{NORM} = |504000/2^{10} -1| = 493$. Für die binäre Darstellung von $f_{NORM}$ sind also $\lceil \log_2 493) \rceil = 9$ *Bit* vorzusehen. Für einen geeigneten binären Exponenten $E_{NORM}$ werden $\lceil \log_2(\log_2(493)) \rceil = 4$ *Bit* benötigt. Die komprimierte Darstellung benötigt nun einmalig 27 Bit für den Startwert $x_0 = y_0 = W(t_0)$ und 51 mal 10 Bit für die weiteren 51 Wochendifferenzen $d_i$ zuzüglich 9 Bit für den Normierungsfaktor bzw. 4 Bit für den binären Exponenten. In Summe werden also 546 Bit = 69 Byte (incl. freiem Normierungsfaktor) bzw. 541 Bit = 68 Byte (incl. binärer Exponent) benötigt. Der Speicherplatzbedarf lässt sich in diesem Beispiel um ca. 67% (208 Byte vs. 68 Byte) reduzieren, also auf etwa ein Drittel der unkomprimierten Darstellung.

Nimmt man Darstellungsfehler in Kauf, dann lässt sich durch das erfindungsgemäße Verfahren eine beträchtliche Datenreduktion für eine Folge insbesondere voneinander abhängiger numerischer Werte erreichen. Der tolerierbare Darstellungsfehler kann je nach Erfordernis frei gewählt werden und lässt so eine hohe oder niedrige Kompression der Wertefolge zu. Das Verfahren ermöglicht es, Verbrauchserfassungsgeräte um eine Verbrauchswerthistorie zu erweitern, ohne eine teuere Speichererweiterung vorsehen zu müssen. Dadurch können Zwischenablesungen vermieden werden. Ferner gestattet das Verfahren die Konstruktion kurzer Datentelegramme mit umfassenden Verbrauchswerthistorien. Für Erfassungsgeräte mit einer Funkschnittstelle bedeutet dies einen reduzierten Energiebedarf für die Funkaussendung. Wertehistorien in jedem einzelnen Erfassungsgerät erhöhen die Ausfallsicherheit von Funksystemen, bei denen die Wertehistorie bislang nur in einem zentralen Datensammler gebildet wurde. In duty-cycle-beschränkten Frequenzbändern (LPD 868-MHz-Bänder mit 10%, 1% 0,1% duty cycle) gestattet die Komprimierung der Funkbotschaften zudem eine höhere Senderate bei gleichbleibenden Zulassungsbeschränkungen. Die Verkürzung von Datentelegrammen reduziert die Eigenkollisionsrate vorteilhaft auf allen Schnittstellen, die ein gemeinsames Übertragungsmedium nutzen. Hier sind die drahtlose Hochfrequenzübertragung oder drahtgebundene Bussysteme ohne geregelte Zugriffssteuerung zu nennen. Das angegebene Rundungsverfahren stellt zudem sicher, dass sich Darstellungsfehler nicht unzulässig über die gesamte Folge komprimierter Werte akkumulieren.

Insgesamt wird durch die Datenkompression ein effektives Verfahren zur Einsparung von Speicherplatz für eine Folge von numerischen (Mess-)Werten angegeben. Das erfindungsgemäße Verfahren ist insbesondere auf die Bedürfnisse der wohnungswirtschaftlichen Verbrauchswerterfassung angepasst, bei der abrechnungsrelevante numerische Daten in Form einer Folge von numerischen Verbrauchswerten auftreten, die sukzessive über die Abrechnungsperiode akkumuliert werden. Das Volumen derartiger Daten wird mit der erfindungsgemä-ßen Lösung besonders effektiv vermindert.

**Patentansprüche**

1. Verfahren zur Datenübertragung von Verbrauchswerten per Funk und zur Einsparung von Speicherplatz, den eine·Folge von aus einem Verbrauchserfassungsgerät gewonnenen numerischen Werten ($x_i$) in einer B-nären Zahlendarstellung mit s Stellen in einem Datenspeicher für die Speicherung und Funkübertragung von Wertehistorien in einem Verbrauchserfassungsgerät einnimmt, bei dem ein gemeinsamer Normierungsfaktor ($f_{NORM}$, f) bestimmt und in dem Datenspeicher abgespeichert wird, bei dem die numerischen Werte ($x_i$) vor der Speicherung in dem Datenspeicher durch Division mit dem Normierungsfaktor ($F_{NORM}$, f) und anschließender Rundung in komprimierte numerische Werte ($y_i$) mit k Stellen überführt werden, wobei k kleiner als s ist, und bei dem die komprimierten numerischen Werte ($y_i$) als Verbrauchswerte per Funk übertragen werden, wobei zu jedem komprimierten numerischen Wert ($y_i$) ein zugehöriger Rundungsfehler ($r_i$) mit abgespeichert wird, der nicht mit übertragen wird, und wobei aus den Komprimierten numerischen Werten ($y_i$) und den zugehörigen gespeicherten Rundungsfehlern ($r_i$) die numerischen Werte ($x_i$) verlust frei Zurückgewonnen werden, der Normierungsfaktor ($F_{NORM}$, f) neu bestimmt wird, wenn sich die Folge numerischer Werte ($x_i$) durch skukzessive Hinzufügen neuer Werte ($x_i$) und/oder Entfernen alter Werte ($x_i$) ändert, und die numerischen Werte ($x_i$) wiederholt Komprimiert werden.

2. Verfahren nach Anspruch 1, **dadurch gekennzeichnet, dass** durch die komprimierten numerischen Werte ($y_i$) alle k Stellen genutzt werden.

3. Verfahren nach Anspruch 1 oder 2, **dadurch gekennzeichnet, dass** der Normierungsfaktor ($F_{NORM}$, f) aus dem Maximalwert der numerischen Werte ($x_i$) bestimmt wird.

4. Verfahren nach einem der vorhergehenden Ansprüche, **dadurch gekennzeichnet, dass** der Normierungsfaktor ($F_{NORM}$, f) als Potenz $B^E$ gebildet wird.

5. Verfahren nach einem der vorhergehenden Ansprüche, **dadurch gekennzeichnet, dass** bei der Überführung der numerischen Werte ($x_i$) in die komprimierten numerischen Werte ($y_i$) auftretende Ungenauigkeiten in einem Fehlerakkumulator (F) aufakkumuliert werden.

6. Verfahren nach Anspruch 5, **dadurch gekennzeichnet, dass** der komprimierte numerische Wert ($y_i$) aufgerundet und der Fehlerakkumulator (F) entsprechend vermindert wird, sobald der Fehlerakkumulator (F) eine vorgebbare Schwelle überschreitet.

7. Verfahren nach Anspruch 6, **dadurch gekennzeichnet, dass** die vorgebbare Schwelle gerade die Hälfte des Normierungsfaktors ($f_{NORM}$, f) beträgt und der Fehlerakkumulator (F) um den Normierungsfaktor ($f_{NORM}$, f) vermindert wird.

8. Verfahren nach einem der vorhergehenden Ansprüche, **dadurch gekennzeichnet, dass** mindestens ein numerischer Wert ($x_i$) unkomprimiert abgespeichert wird.

9. Verfahren nach einem der vorhergehenden Ansprüche, **dadurch gekennzeichnet, dass** vor der Anwendung des Normierungsfaktors ($f_{NORM}$, f) aus jeweils aufeinanderfolgenden numerischen Werten ($x_i$) und ($x_{i-1}$) jeweils ein Differenzwert ($d_i$) gebildet wird und die Differenzwerte ($d_i$) mit dem Normierungsfaktor ($f_{NORM}$, f) in die komprimierten numerischen Werte ($y_i$) mit k Stellen überführt werden.

10. Verfahren nach einem der vorhergehenden Ansprüche, **dadurch gekennzeichnet, dass** die Anzahl k der Stellen der komprimierten numerischen Werte ($y_i$) abhängig von der gewünschten Genauigkeit festgelegt wird.

11. Verbrauchserfassungsgerät mit einen Verbrauchserfassungssensor, einem Datenspeicher zum Abspeichern der in einer B-nären Zahlendarstellung mit s Stellen erfassten Verbrauchswerte ($x_i$) und einer Recheneinheit, **dadurch gekennzeichnet, dass** die Recheneinheit Mittel zur Bestimmung eines gemeinsamen Normierungsfaktors ($f_{NORM}$, f) und zu dessen Abspeicherung in dem Datenspeicher und Mittel zur Überführung der numerischen Werte ($x_i$) vor der Speicherung in dem Datenspeicher durch Division mit dem Normierungsfaktor ($f_{NORM}$, f) und anschließende Rundung in komprimierte numerische Werte ($y_i$) mit k Stellen aufweist, wobei k kleiner als s ist, und dass ein Funksender zur Übertragung der als komprimierte numerische Werte ($y_i$) vorliegenden Verbrauchswerte vorgesehen ist, wobei die Recheneinheit ferner zur Durchführung des Verfahrens nach einem der Ansprüche 1 bis 10 eingerichtet ist.

**Claims**

1. A method for the radio data transmission of consumption values and for saving storage space occupied in a memory for the storage and radio transmission of value histories in a consumption recording device by a sequence of numerical values ($x_i$) obtained from a consumption recording device in a binary number notation with s digit positions, in which a common normalization factor ($f_{NORM}$, f) is determined and stored in the memory, in which the numerical values ($x_i$) are converted prior to storage in the memory by division by the normalization factor ($f_{NORM}$, f) and subsequent rounding into compressed numerical values ($y_i$) with k digit positions, wherein k is smaller than s, and in which the compressed numerical values ($y_i$) are transmitted by radio as consumption values, wherein for each compressed numerical value ($y_i$) an associated rounding error ($r_i$) is also stored, which is not included in the transmission, and wherein from the compressed numerical values ($y_i$) and the associated stored rounding errors ($r_i$) the numerical values ($x_i$) are restored without loss, the normalization factor (form, f) is re-determined if the sequence of numerical values ($x_i$) changes through the successive addition of new values ($x_i$) and/or removal of old values ($x_i$) and the numerical values ($x_i$) are repeatedly compressed.

2. The method according to claim 1, **characterized in that** all k digit positions are used by the compressed numerical values ($y_i$).

3. The method according to claim 1 or 2, **characterized in that** the normalization factor ($f_{NORM}$, f) is determined from the maximum value of the numerical values ($x_i$).

4. The method according to one of the preceding claims, **characterized in that** the normalization factor ($f_{NORM}$, f) takes the form of the power BE.

5. The method according to one of the preceding claims, **characterized in that** inaccuracies arising during conversion of the numerical values ($x_i$) into the compressed numerical values ($y_i$) are accumulated in an error accumulator (F).

6. The method according to claim 5, **characterized in that** the compressed numerical value ($y_i$) is rounded off and the error accumulator (F) is reduced accordingly, as soon as the error accumulator (F) exceeds a predeterminable threshold.

7. The method according to claim 6, **characterized in that** the predeterminable threshold amounts to precisely half the normalization factor ($F_{NORM}$, f) and the error accumulator (F) is reduced by the normalization factor ($F_{NORM}$, f).

8. The method according to one of the preceding claims, **characterized in that** at least one numerical value ($x_i$) is stored in uncompressed form.

9. The method according to one of the preceding claims, **characterized in that** prior to application of the normalization factor $F_{NORM}$, f), a differential value ($d_i$) is formed in each case from in each case successive numerical values ($x_i$) and ($x_{i-1}$) and the differential values ($d_i$) are converted using the normalization factor ($f_{NORM}$, f) into compressed numerical values ($y_i$) with k digit positions.

10. The method according to one of the preceding claims, **characterized in that** the number k of digit positions of the compressed numerical values ($y_i$) is fixed depending on the desired accuracy.

11. A consumption recording device with a consumption recording sensor, a memory for storing the consumption values ($x_i$) recorded in a binary number notation with s digit positions and a processing unit, **characterized in that** the processing unit comprises means for determining a common normalization factor ($F_{NORM}$, f) and for storing it in the memory and means for converting the numerical values ($x_i$) prior to storage in the memory by division by the normalization factor ($f_{NORM}$, f) and subsequent rounding into compressed numerical values ($y_i$) with k digit positions, wherein k is smaller than s, and that a radio transmitter is provided for transmission of the consumption values existing as compressed numerical values ($y_i$), wherein the processing unit is further set up to perform the method according to one of the claims 1 to 10.

**Revendications**

1. Procédé de transmission de données de valeurs de consommation par radio et d'économie de place en mémoire, qui prend une séquence de valeurs numériques ($x_l$) acquises depuis un appareil de détection de consommation dans une représentation numérique binaire avec s emplacements dans une mémoire de données pour la mémorisation et la transmission radio d'historiques de valeurs dans un appareil de détection de consommation, dans lequel un facteur de normalisation commun ($f_{NORM}$, f) est déterminé et mémorisé dans la mémoire de données, dans lequel les valeurs numériques sont converties avant la division avec le facteur de normalisation ($f_{NORM}$, f) et arrondi consécutif en valeurs numériques compressées ($y_i$) avec k emplacements, dans lequel k est plus petit que s et dans lequel les valeurs numériques compressées ($y_l$) sont transmises par radio comme des valeurs de consommation, dans lequel une erreur d'arrondi correspondante ($r_l$) est mémorisée conjointement à chaque valeur numérique compressée ($y_l$), laquelle n'est pas transmise conjointement, et dans lequel les valeurs numériques ($x_l$) sont récupérées sans pertes d'après les valeurs numériques compressées ($y_l$) et les erreurs d'arrondi mémorisées correspondantes ($r_l$), le facteur de normalisation ($f_{NORM}$, f) est à nouveau déterminé, quand la séquence de valeurs numériques( $x_l$) varie par ajout de nouvelles valeurs ($x_l$) et/ou retrait d'anciennes valeurs ($x_l$).

2. Procédé selon la revendication 1, **caractérisé en ce que** tous les k emplacements sont utilisés par les valeurs numériques compressées ($y_l$).

3. Procédé selon les revendications 1 ou 2, **caractérisé en ce que** le facteur de normalisation ($f_{NORM}$, f) est déterminé d'après la valeur maximale des valeurs numériques ($X_l$).

4. Procédé selon une des revendications précédentes, **caractérisé en ce que** le facteur de normalisation ($f_{NORM}$, f) est formé par une puissance $B^E$.

5. Procédé selon une des revendications précédentes, **caractérisé en ce que** les imprécisions survenant lors de la conversion des valeurs numériques ($x_l$) en valeurs numériques compressées ($y_l$) sont accumulées dans un accumulateur d'erreurs (F).

6. Procédé selon la revendication 5, **caractérisé en ce que** la valeur numérique compressée ($y_l$) est arrondie et l'accumulateur d'erreurs (F) est diminué de manière correspondante, dès que l'accumulateur d'erreurs (F) dépasse un seuil prescriptible.

7. Procédé selon la revendication 6, **caractérisé en ce que** le seuil prescriptible correspond à la moitié du facteur de normalisation ($f_{NORM}$, f) et l'accumulateur d'erreurs (F) est diminué du facteur de normalisation ($f_{NORM}$, f).

8. Procédé selon une des revendications précédentes, **caractérisé en ce que** au moins une valeur numérique ($x_l$) est mémorisée sans être compressée.

9. Procédé selon une des revendications précédentes, **caractérisé en ce que** avant l'utilisation du facteur de normalisation ($F_{NORM}$, f) une valeur de différence ($d_l$) respective est formée à partir de valeurs numériques successives respectives ($x_l$) et ($x_{l-1}$) et la valeur de différence ($d_l$) est convertie avec le facteur de normalisation ($f_{NORM}$, f) en valeurs numériques compressées ($y_l$) avec k emplacements.

10. Procédé selon une des revendications précédentes, **caractérisé en ce que** le nombre k des emplacements des valeurs numériques compressées ($y_l$) est déterminé en fonction de la précision souhaitée.

11. Appareil de détection de consommation comportant un capteur de détection de consommation, une mémoire de données pour mémoriser les valeurs de consommation ($x_l$) détectées en une représentation numérique binaires avec s emplacements et une unité informatique, **caractérisé en ce que** l'unité informatique présente un moyen de détermination d'un facteur de normalisation commun ($F_{NORM}$, f) et de mémorisation de ce dernier dans la mémoire de données et un moyen de conversion des valeurs numériques ($x_l$) avant la mémorisation dans la mémoire de données par division avec le facteur de normalisation ($f_{NORM}$, f) et arrondi consécutif en valeurs numériques compressées ($y_l$) avec k emplacements, dans lequel k est plus petit que s, et **en ce que** un émetteur radio pour transmettre les valeurs de consommation se présentant comme des valeurs numériques compressées ($y_l$) est prévu, dans lequel l'unité informatique est en outre conçue afin de mettre en oeuvre le procédé selon une des revendications 1 à 10.

| Auflö-sung | Wertebereich pos. / 2er Kompl. | LSB-Fehler Prozent | Wertebereiche und Speicherbedarf für kummulierte Verbräuche | | | |
|---|---|---|---|---|---|---|
| | | | 12 Monate | 24 Halbmon. | 52 Wochen | 366 Tage |
| 4 Bit | 0 bis 15 | 6,250% | 0 bis 180 | 0 bis 360 | 0 bis 780 | 0 bis 5490 |
| | -8 bis 7 | | -96 bis 84 | -192 bis 168 | -416 bis 364 | -2928 bis 2562 |
| | | | 48 Bit | 96 Bit | 208 Bit | 1464 Bit |
| | | | 6 Byte | 12 Byte | 26 Byte | 183 Byte |
| 5 Bit | 0 bis 31 | 3,125% | 0 bis 372 | 0 bis 744 | 0 bis 1612 | 0 bis 11346 |
| | -16 bis 15 | | -192 bis 180 | -384 bis 360 | -832 bis 780 | -5856 bis 5490 |
| | | | 60 Bit | 120 Bit | 260 Bit | 1830 Bit |
| | | | 8 Byte | 15 Byte | 33 Byte | 229 Byte |
| 6 Bit | 0 bis 63 | 1,563% | 0 bis 756 | 0 bis 1512 | 0 bis 3276 | 0 bis 23058 |
| | -32 bis 31 | | -384 bis 372 | -768 bis 744 | -1664 bis 1612 | -11712 bis 11346 |
| | | | 72 Bit | 144 Bit | 312 Bit | 2196 Bit |
| | | | 9 Byte | 18 Byte | 39 Byte | 275 Byte |
| 7 Bit | 0 bis 127 | 0,781% | 0 bis 1524 | 0 bis 3048 | 0 bis 6604 | 0 bis 46482 |
| | -64 bis 63 | | -768 bis 756 | -1536 bis 1512 | -3328 bis 3276 | -23424 bis 23058 |
| | | | 84 Bit | 168 Bit | 364 Bit | 2562 Bit |
| | | | 11 Byte | 21 Byte | 46 Byte | 321 Byte |
| 8 Bit | 0 bis 255 | 0,391% | 0 bis 3060 | 0 bis 6120 | 0 bis 13260 | 0 bis 93330 |
| | -128 bis 127 | | -1536 bis 1524 | -3072 bis 3048 | -6656 bis 6604 | -46848 bis 46482 |
| | | | 96 Bit | 192 Bit | 416 Bit | 2928 Bit |
| | | | 12 Byte | 24 Byte | 52 Byte | 368 Byte |
| 9 Bit | 0 bis 511 | 0,195% | 0 bis 6132 | 0 bis 12264 | 0 bis 26572 | 0 bis 187026 |
| | -256 bis 255 | | -3072 bis 3060 | -6144 bis 6120 | -13312 bis 13260 | -93696 bis 93330 |
| | | | 108 Bit | 216 Bit | 468 Bit | 3294 Bit |
| | | | 14 Byte | 27 Byte | 59 Byte | 412 Byte |
| 10 Bit | 0 bis 1023 | 0,098% | 0 bis 12276 | 0 bis 24552 | 0 bis 53196 | 0 bis 374418 |
| | -512 bis 511 | | -6144 bis 6132 | -12288 bis 12264 | -26624 bis 26572 | -187392 bis 187026 |
| | | | 120 Bit | 240 Bit | 520 Bit | 3660 Bit |
| | | | 15 Byte | 30 Byte | 65 Byte | 458 Byte |
| 11 Bit | 0 bis 2047 | 0,049% | 0 bis 24564 | 0 bis 49128 | 0 bis 106444 | 0 bis 749202 |
| | -1024 bis 1023 | | -12288 bis 12276 | -24576 bis 24552 | -53248 bis 53196 | -374784 bis 374418 |
| | | | 132 Bit | 264 Bit | 572 Bit | 4026 Bit |
| | | | 17 Byte | 33 Byte | 72 Byte | 504 Byte |
| 12 Bit | 0 bis 4095 | 0,024% | 0 bis 49140 | 0 bis 98280 | 0 bis 212940 | 0 bis 1498770 |
| | -2048 bis 2047 | | -24576 bis 24564 | -49152 bis 49128 | -106496 bis 106444 | -749568 bis 749202 |
| | | | 144 Bit | 288 Bit | 624 Bit | 4392 Bit |
| | | | 18 Byte | 36 Byte | 78 Byte | 549 Byte |

**Fig. 1**

| n akkumulierte Aus-gangswerte $x_i$ mit s Stellen (genau) | → | n komprimierte Ergebniswerte $y_i$ mit k Stellen | → | n dekomprimierte Werte $x_i$ der Rücktransformation mit s Stellen (und akzeptiertem Restfehler) |
|---|---|---|---|---|
| $x_0 = W(t_0)$ | → | $y_0 = x_0$ | → | $\hat{x}_0 = y_0 = W(t_0)$ |
| $x_1 = x_0 + d_1$ $d_1 = W(t_1) - W(t_0)$ | → | $y_1 = \left\lfloor \dfrac{d_1}{f_{NORM}} \right\rfloor + r_1$ | → | $\hat{x}_1 = \hat{x}_0 + f_{NORM} \cdot y_1 \approx W(t_1)$ |
| $x_2 = x_1 + d_2$ $d_2 = W(t_2) - W(t_1)$ | → | $y_2 = \left\lfloor \dfrac{d_2}{f_{NORM}} \right\rfloor + r_2$ | → | $\hat{x}_2 = \hat{x}_1 + f_{NORM} \cdot y_2 \approx W(t_2)$ |
| $x_3 = x_2 + d_3$ $d_3 = W(t_3) - W(t_2)$ | → | $y_3 = \left\lfloor \dfrac{d_3}{f_{NORM}} \right\rfloor + r_3$ | → | $\hat{x}_3 = \hat{x}_2 + f_{NORM} \cdot y_3 \approx W(t_3)$ |
| . . . | . . . | . . . | . . . | . . . |
| $x_{n-2} = x_{n-3} + d_{n-2}$ $d_{n-2} = W(t_{n-2}) - W(t_{n-3})$ | → | $y_{n-2} = \left\lfloor \dfrac{d_{n-2}}{f_{NORM}} \right\rfloor + r_{n-2}$ | → | $\hat{x}_{n-2} = \hat{x}_{n-3} + f_{NORM} \cdot y_{n-2} \approx W(t_{n-2})$ |
| $x_{n-1} = x_{n-2} + d_{n-1}$ $d_{n-1} = W(t_{n-1}) - W(t_{n-2})$ | → | $y_{n-1} = \left\lfloor \dfrac{d_{n-1}}{f_{NORM}} \right\rfloor + r_{n-1}$ | → | $\hat{x}_{n-1} = \hat{x}_{n-2} + f_{NORM} \cdot y_{n-1} \approx W(t_{n-1})$ |

wobei $\lfloor x \rfloor$ = größte ganze Zahl ≤ $x_i$ i

**Fig. 2**

| Anzahl der Bits $E_{NORM}$ | Faktoren: $2^{E_{NORM}}$ | max. Faktor $2^{E_{NORM}}$ | Anzahl der Bits $f_{NORM}$ | Wertebereich $f_{NORM}$ | Ersparnis $E_{NORM}$ vs. $f_{NORM}$ |
|---|---|---|---|---|---|
| 1 | $2^0$ und $2^1$ | 2 | 1 | 1 bis 2 | 0 Bit |
| 2 | $2^0, 2^1, 2^2, 2^3$ | 8 | 3 | 1 bis 8 | 1 Bit |
| 3 | $2^0, 2^1, 2^2, ..., 2^7$ | 128 | 7 | 1 bis 128 | 4 Bit |
| 4 | $2^0, 2^1, 2^2, ..., 2^{15}$ | 32768 | 15 | 1 bis 32768 | 11 Bit |
| 5 | $2^0, 2^1, 2^2, ..., 2^{31}$ | 2147483648 | 31 | 1 bis $2^{31}$ | 26 Bit |

**Fig. 3**

Fig. 4

Fig. 5

**Fig. 6**

| E | ganzzahliger binärer Exponent |
|---|---|
| f | ganzzahliger Normierungsfaktor |
| F | ganzzahliger vorzeichenbehafteter Fehlerakkumulator |
| i | Schleifenzähler und Feldindex = 0 bis n-1 |
| k | Anzahl der Bits für die komprimierte Darstellung in den Elementen y[i] |
| n | Anzahl der Feldelemente von x[i] und y[i] mit i = 0 bis n-1 |
| r[i] | Folge der Restfehler für jede Berechnungsstufe |
| x[i] | Ausgangswertefeld der unkomprimierten Daten mit n Elementen |
| y[i] | Ergebniswertefeld in komprimierter k-Bit-Darstellung mit n Elementen |
| := | Zuweisungsoperator von der rechten Seite an die linke Seite |
| / | Ganzzahldivision (teilen durch eine Zweierpotenz $2^E$ = Bitschieben rechts) |
| and | bitweise binäre UND-Verknüpfung |
| mod | Modulo-Operator liefert den Divisionsrest einer Ganzzahldivision |

**Fig. 7**

## IN DER BESCHREIBUNG AUFGEFÜHRTE DOKUMENTE

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

### In der Beschreibung aufgeführte Patentdokumente

- US 6028893 A
- JP 06319178 B
- DE 3411962
- US 20020145537 A

### In der Beschreibung aufgeführte Nicht-Patentliteratur

- **G. K. WALLACE.** The JPEG Still Picture Compression Standard. Association for Computing Machinery, vol. 34, 30-44